# EUROPEAN PATENT SPECIFICATION

(11) **EP 0 405 523 B1**
(45) Date of publication and mention of the grant of the patent: **15.02.1995**
(21) Application number: 90112291.1
(22) Date of filing: 27.06.1990
(51) Int. Cl.: H03L 7/089

(54) **Charge pump circuit**
Lade-Entladeschaltung
Circuit charge-décharge

(30) Priority: 27.06.1989 JP 165113/89
(43) Date of publication of application: 02.01.1991
(73) Proprietor: SONY CORPORATION, Tokyo (JP)
(72) Inventor: Takagi, Kotaro, C/o Sony Corporation, Shinagawa-ku, Tokyo (JP); Yokoya, Satoshi, C/o Sony Corporation, Shinagawa-ku, Tokyo (JP)
(74) Representative: TER MEER STEINMEISTER & PARTNER GbR

(56) References cited:
- EP-A- 0 238 041
- GB-A- 2 198 562
- US-A- 4 321 483
- US-A- 4 745 372

## Description

The present invention relates to a PLL-system, specifically to a charge pump circuit within such system.

The document US-A-4,745,372 discloses in its Figs. 1 and 8, and in the related description, a charge pump circuit within a PLL-system, said circuit comprising:
- a series connection of a first transistor and a second transistor of the type complementary to the type of said first transistor, between a power source voltage terminal and ground;
- a third transistor being connected to said second transistor to form a mirror circuit together with said second transistor; and
- a transistor means being connected to said first transistor and being connected in series with said third transistor between said power voltage terminal and ground.

In this prior art charge pump circuit, the transistor means comprises only a single transistor acting as a diode, to form a mirror circuit with the first transistor. The diode-transistors in both mirror circuits are connected to each other via a resistor which may be shortcut by a switch. Depending on whether the switch is permanently open or whether it is pulsed, the charge pump circuit operates in one of two different modes. When the switch is pulsed, the circuit is in a synchronized mode having a narrow noise band, whereas, when the switch is open, the circuit provides fast response speed in a pull-in transition. This prior art charge pump circuit has the disadvantage that, when it is used in a PLL-system, the cut-off frequency of the loop filter cannot be adjusted independently from the loop gain of the system, and vice versa.

It is therefore the object of the present invention to provide a charge pump circuit within a PLL-system, for charging a loop filter, wherein the cut-off frequency of the loop filter is independent of the loop gain of the PLL-system, and vice versa.

The circuit of the present invention is defined by the teaching of the enclosed claim.

The present invention will be explained in more detail based on embodiments which are illustrated by the accompanying drawings.
Fig. 1 is a partially schematic circuit diagram illustrating a first embodiment of a charge pump circuit and PLL-system in accordance with the present invention;
Fig. 2 is a graph of certain operational characteristics of the PLL-system of the present invention; and
Fig. 3 is a partially schematic circuit diagram illustrating a second embodiment of a charge pump circuit and PLL-system in accordance with the present invention.

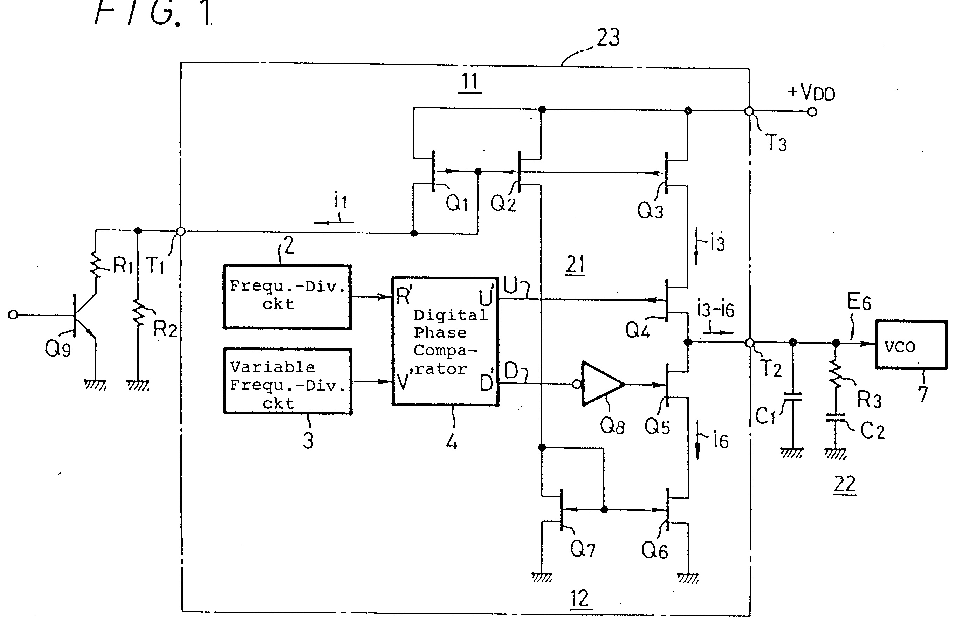

Fig. 1 illustrates a phase locked loop system in accordance with a first embodiment of the present invention.

In a charge pump circuit 21 of the Fig. 1 embodiment, the source-drain paths of p-channel FETs Q₃ and Q₄ are connected in series between a positive voltage power source terminal T₃ and an output terminal T₂ of the charge pump circuit 21. Charge pump circuit 21 also includes n-channel FETs Q₅ and Q₆ whose drain-source paths are connected in series between the output terminal T₂ and circuit ground. The FET Q₃ is a current source transistor which supplies a charging current i₃ of constant magnitude in a first direction toward the output terminal T₂ for charging a loop filter 22 described in greater detail hereinbelow. The FET Q₆ is a current sink transistor which draws a discharging current i₆ of constant magnitude in a second direction from the output terminal T₂ to circuit ground for discharging the loop filter 22. The FET Q₄ acts as a first switching transistor for controlling the application of the charging current i₃ supplied by the current source transistor Q₃, while the FET₅ Q₅ serves as a second switching transistor for controlling the flow of the discharging current i₆ from the output terminal T₂ to ground through the current sink transistor Q₆.

A current mirror circuit 11 includes a p-channel FET Q₁ at an input side thereof, the FET Q₁ having a source electrode connected with terminal T₃ and drain and gate electrodes both connected to a control terminal T₁ of the charge pump circuit 21. The FET Q₃ is arranged at an output side of the current mirror circuit 11 such that its gate electrode is coupled with that of the FET Q₁. A further p-channel FET Q₂ is also connected at the output side of the current mirror circuit 11 such that its gate electrode is coupled with that of the FET Q₁ and its source electrode is connected with that of FET Q₁ to the terminal T₃.

A second current mirror circuit 12 includes an n-channel FET Q₇ whose source electrode is connected to circuit ground and whose drain and gate electrodes are connected with the drain electrode of the FET Q₂. The current sink transistor Q₆ forms the output side of the current mirror circuit 12 such that its gate electrode is connected with that of the FET Q₇.

The output terminal U′ of the digital phase comparison circuit 4 is connected to the gate electrode of the first switching transistor Q₄ and the output terminal D′ of the digital phase comparison circuit 4 is coupled through an inverter Q₈ to the gate electrode of the second switching transistor Q₅. The digital phase comparison.circuit 4 and the charge pump circuit 21 together with the frequency-dividing circuits 2 and 3, are fabricated as an integrated circuit 23, as indicated in Fig. 1.

A resistor R₂ is connected between the control terminal T₁ and circuit ground. A resistor R₁ has a first terminal connected to the control terminal T₁ and a second terminal connected with the collector of an npn transistor Q₉ whose emitter is connected to circuit ground.

The loop filter 22 includes a capacitor C₁ connected between the output terminal T₂ and circuit ground. The loop filter 22 further includes a resistor R₃ having a first terminal connected with the output terminal T₂ of the charge pump circuit 21, and a capacitor C₂ having a first terminal connected with a second terminal of the resistor R₃ and a second terminal connected with the circuit ground. The loop filter 22 produces a voltage E₆ at the terminal T₂ which the loop filter 22 supplies to the control terminal of the VCO 7.

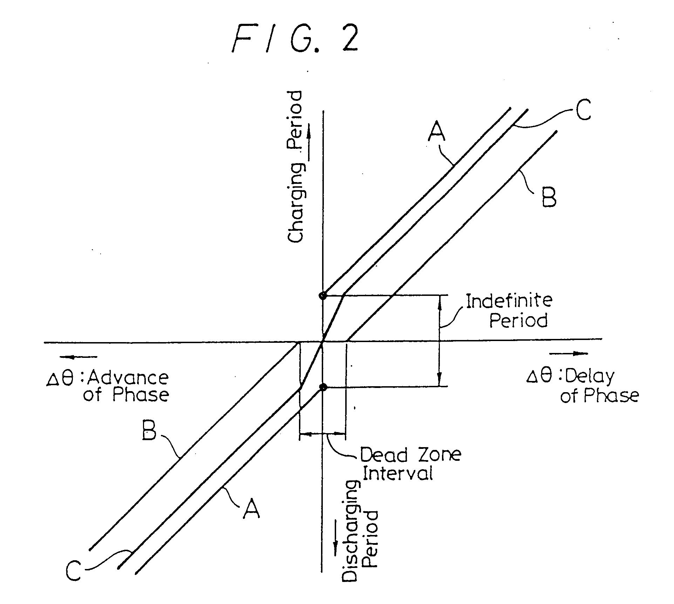

The digital phase comparison circuit 4 receives the first and second phase comparison signals R and V as inputs and produces the first and second phase difference signals U and D as outputs, as known e.g. from US-A- 4,745,372. Accordingly, the relationship of the first and second phase difference signals U and D produced by the phase comparison circuit 4 to the phase difference between the first and second phase comparison signals R and V provided as inputs thereto is expressed essentially by the discontinuous line A of Fig. 2.

In operation, the current i₁ flowing in the FET Q₁ has a constant magnitude depending on a signal level applied to the base of the transistor Q₉, as discussed more fully hereinbelow. Since the FETs Q₁ and Q₃ form respective input and output portions of the current mirror circuit 11, the magnitude of the current i₃ flowing in the source-drain path of the FET Q₃ will be equal to that of the current i₁ of the FET Q₁. Since the FETs Q₁ and Q₂ likewise form respective input and output portions of the current mirror circuit 11, the current flowing in the source-drain path of the FET Q₂ is also equal in magnitude to that of the current i₁ and, therefore, to that of the current i₃. Since the FETs Q₇ and Q₆ constitute input and output portions, respectively, of the current mirror circuit 12, the current i₆ flowing in the source-drain path of the FET Q₆ is equal to the current flowing in the source-drain path of the FET Q₇. Since the current flowing in the source-drain path of the FET Q₇ is equal to that flowing in the source-drain path of the FET Q₂ and, therefore, is also equal to that of i₃, it is apparent that the magnitudes of the currents i₃ and i₆, when permitted to flow through the switching transistors Q₄ and Q₅, respectively, will have the same magnitude. Accordingly, the charge pump circuit 21 forces the magnitudes of the currents i₃ and i₆ to equal that of the reference current i₁ whenever the respective switching transistors Q₄ and Q₅ are turned ON.

In operation, where the phase comparison signal V is phase delayed with respect to the phase comparison signal R such that the phase difference signal U is in a logic "0" state and the phase difference signal D is in a logic "1" state, the switching transistor Q₄ is turned ON and the switching transistor Q₅ is turned OFF. Accordingly, the constant current i₃ is then provided to the loop filter 22 to charge the capacitors C₁ and C₂ to increase the level of the output voltage E₆ of the loop filter 22. Consequently, the phase (that is, the oscillation frequency) of the oscillation signal produced by the VCO 7 is advanced. Since the capacitors C₁ and C₂ are charged by a current i₃ having a constant magnitude, the voltage level E₆ is linearly increased thereby.

When the second phase comparison signal V is phase advanced with respect to the first phase comparison signal R so that the first phase difference signal U is in a logic "1" state while the second phase difference signal D is in a logic "0" state, the first switching transistor Q₄ is then turned OFF while the second switching transistor Q₅ is turned ON such that the capacitors C₁ and C₂ are thereby discharged by the constant current i₆. Consequently, this simultaneously decreases the level of the output voltage E₆ of the loop filter 22 in a linear fashion, such that the phase of the oscillation signal produced by the VCO 7 is delayed.

Furthermore, at such times that the first and second phase comparison signals R and V are in phase such that the first and second phase difference signals U and D are in a logic "1" state, the first and second switching transistors Q₄ and Q₅ are both turned OFF, so that neither the current i₃ nor the current i₆ is permitted to flow to the output terminal T₂. Consequently, the capacitors C₁ and C₂ are neither charged or discharged and the output voltage level E₆ is maintained at a constant value such that the phase of the oscillation signal produced by the VCO 7 is likewise unchanged.

As noted above, where the phase comparison signals R and V are in phase, during a short period of time commencing from the trailing edges of the phase comparison signals R and V, both of the first and second phase difference signals U and D switch to a logic "0" state before returning to a logic "1" state at the end of the short time period. Since, however, the magnitudes of the charging and discharging currents i₃ and i₆, respectively, are equal, they add to zero when both of the first and second switching transistors Q₄ and Q₅ are turned ON by the logic "0" levels of the first and second phase difference signals U and D. Accordingly, the capacitors C₁ and C₂ of the loop filter 22 are neither charged nor discharged at such time and the level of the output voltage E₆ is maintained at a constant value so that the phase of the oscillation signal produced by the VCO 7 is unchanged.

With reference again to Fig. 2, the continuous line C indicates the relationship of the phase difference Δϑ between the phase comparison signals V and R input to the phase comparison circuit 4 and the charging and discharging periods produced in response thereto by the charge pump circuit 21. It will be seen therefrom that a linear relationship exists between the phase difference Δϑ and the resulting charging and discharging periods. Since the charge pump circuit 21 supplies charging and discharging currents i₃ and i₆, respectively, which have a constant magnitude, it will be appreciated that the Fig. 1 embodiment provides a linear relationship between the phase difference Δϑ and the control voltage E₆ even at arbitrarily small phase differences. Accordingly, the phase of the oscillation signal produced by the VCO 7 varies linearly with the phase difference Δϑ between the first and second phase comparison signals R and V.

When the transistor Q₉ is turned OFF, the reference current i₁ flows through the resistor R₂ only, such that the reference current i₁ is maintained at a relatively low value by the relatively high impedance presented by the resistor R₂ alone. When however, the transistor Q₉ is turned ON, the current i₁ is able to flow through the parallel combination of resistors R₁ and R₂, such that the magnitude of the current i₁ flowing through the FET Q₁ is increased. Since the currents i₃ and i₆ are equal in magnitude to the reference current i₁, it will be seen that a means is provided for adjusting the magnitudes of the constant currents i₃ and i₆ by controlling the ON-OFF states of the transistor Q₉. Since the output voltage E₆ of the loop filter 22 varies linearly with the magnitudes of the currents i₃ and i₆, it will be seen that, by adjusting the magnitudes of the constant currents i₃ and i₆ by selecting the ON-OFF states of the transistor Q₉, the loop gain of the phase locked loop is thereby adjusted. It will also be appreciated that the lock-up time of the phase locked loop can be selectably reduced by increasing the loop gain in the foregoing manner. Since the cut-off frequency of the loop filter 22 is determined only by the capacitors C₁ and C₂ and the resistor R₃, whose values are unaffected by the magnitudes of the charging and the discharging currents i₃ and i₆, the cut-off frequency of the loop filter 22 is unaffected by adjusting the loop gain in the foregoing manner. It will also be apparent that the loop gain can be made independent of the cut-off frequency.

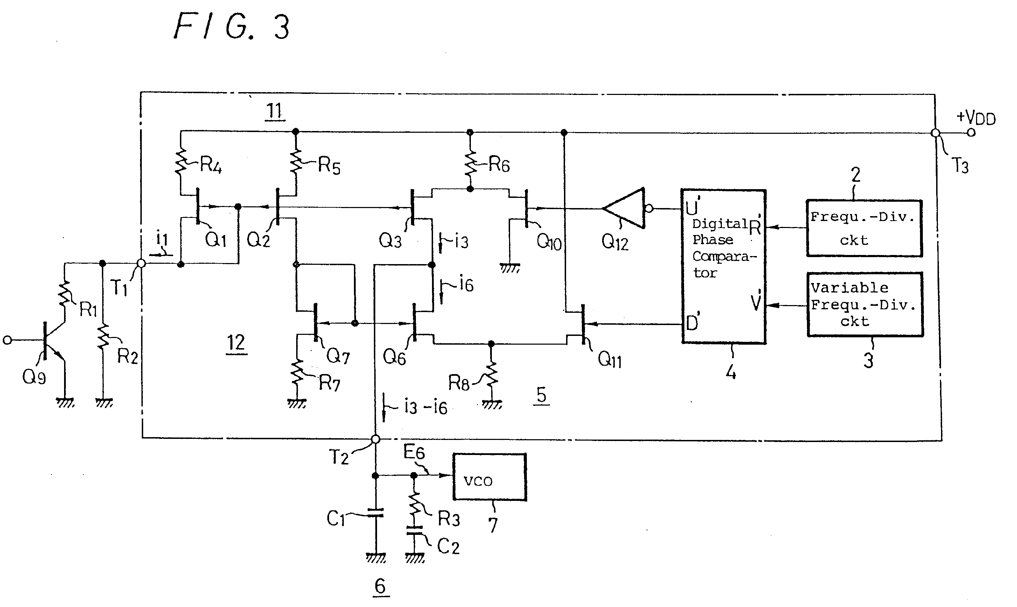

With reference now to Fig. 3, a second embodiment of a phase locked loop system in accordance with the present invention is illustrated therein. Elements of the Fig. 3 embodiment corresponding to elements shown in Fig. 1 bear the same reference numerals.

In the Fig. 3 embodiment, the first and second current source transistors Q₃ and Q₆ are coupled directly to the output terminal T₂, while the source-drain path of the current source transistor Q₃ is coupled to the positive voltage power source terminal T₃ through a resistor R₆, while the source-drain path of the current sink transistor Q₆ is coupled to circuit ground through a resistor R₈. The source of the FET Q₁ is coupled to the positive voltage power supply terminal T₃ through a resistor R₄, while the source of the FET Q₂ is coupled to the positive voltage power source T₃ through a resistor R₅. The source of the FET Q₇ is coupled to circuit ground through a resistor R₇. A p-channel bypass switching FET Q₁₀ has its source-drain path coupled in series with the resistor R₆ between the terminal T₃ and circuit ground and has its gate electrode coupled with the output terminal U′ of the phase comparison circuit 4 through an inverter Q₁₂. Accordingly, the bypass switching transistor Q₁₀ is operative to control the flow of the constant current i₃ supplied by the current source transistor Q₃ by bypassing the current i₃ whenever the first phase difference signal U is high.

An n-channel bypass switching FET Q₁₁ has its source-drain path connected in series through the resistor R₈ between the terminal T₃ and circuit ground and its gate electrode connected with the output terminal D′ of the phase comparison circuit 4. Accordingly, the FET Q₁₁ acts as a second bypass switching transistor for controlling the flow of the constant current i₆ supplied by the current sink transistor Q₆ such that whenever the second phase difference signal supplied at the output terminal D′ of the phase comparison circuit 4 is in a logic "1" state, the second bypass switching transistor Q₁₁ is turned ON to bypass the current i₆ which otherwise would flow through the current sink transistor Q₆. In all other respects, the operation of the Fig. 3 embodiment is identical to that of the Fig. 1 embodiment.

It will be readily appreciated by those skilled in the art that the embodiments of Figs. 1 and 3 may be similarly constructed with the use of bipolar transistors in place of the field effect transistors (FETs) specifically disclosed herein.

Although specific embodiments of the invention have been described in detail herein with reference to the accompanying drawings, it is to be understood that the invention is not limited to those precise embodiments, and that various changes and modifications may be effected therein by one skilled in the art without departing from the scope of the invention as defined in the appended claims.

## Claims

1. Charge pump circuit in a PLL-system with a digital phase comparison circuit, comprising:
- a series connection of a first transistor (Q₃) and a second transistor (Q₆) of the type complementary to the type of said first transistor, between a power source voltage terminal and ground;
- a third transistor (Q₇) being connected to said second transistor to form a mirror circuit together with said second transistor; and
- a transistor means (Q₁, Q₂) being connected to said first transistor (Q₃) and being connected in series with said third transistor (Q₇) between said power voltage terminal and ground;
**characterized in that**
- an input circuit is provided, having a parallel connection between a terminal (T₁) and ground of a first resistor (R₂), and a series connection of a transistor (Q₉) and a second resistor (R₁), the control terminal of said transistor receiving a voltage for controlling its ON-OFF state; and
- said transistor means comprises the following features:
-- it is composed of a fourth transistor (Q₁) in a mirror circuit together with said first transistor (Q₃), and a fifth transistor (Q₂), which transistors are of complementary types and have their control terminals connected to each other;
-- the fifth transistor (Q₂) being connected in series with said third transistor (Q₇) between said power source voltage terminal and ground; and
-- the control terminals of said first, fourth and fifth transistors are connected to the terminal of said input circuit.

## Patentansprüche

1. Ladungspumpschaltung in einem PLL-System mit einer digitalen Phasenvergleichsschaltung, mit:
- einer Reihenschaltung aus einem ersten Transistor (Q₃) und einem zweiten Transistor (Q₆) vom Typ, der zum Typ des ersten Transistors komplementär ist, zwischen einem Spannungsquelleanschluß und Masse;
- einem dritten Transistor (Q₇), der so mit dem zweiten Transistor verbunden ist, daß er zusammen mit diesem eine Spiegelschaltung bildet; und
- einer Transistoreinrichtung (Q₁, Q₂), die mit dem ersten Transistor (Q₃) verbunden ist und in Reihe zum dritten Transistor (Q₇) zwischen den Spannungsquelleanschluß und Masse geschaltet ist;
**dadurch gekennzeichnet**, daß
- eine Eingangsschaltung vorhanden ist, mit einer Parallelschaltung zwischen einem Anschluß (T₁) eines ersten Widerstands (R₂) und Masse und einer Reihenschaltung aus einem Transistor (Q₉) und einem zweiten Widerstand (R₁), wobei der Steueranschluß des Transistors eine Spannung zum Steuern seines EIN/AUS-Zustands erhält; und
- die Transistoreinrichtung die folgenden Merkmale aufweist:
-- sie besteht aus einem vierten Transistor (Q₁) in einer Spiegelschaltung zusammen mit dem ersten Transistor (Q₃) und einem fünften Transistor (Q₂), wobei die Transistoren von komplementärem Typ sind und ihre Steueranschlüsse miteinander verbunden sind;
-- der fünfte Transistor (Q₂) ist in Reihe zum dritten Transistor (Q₇) zwischen den Spannungsquelleanschluß und Masse geschaltet und
-- die Steueranschlüsse des ersten, vierten und fünften Transistors sind mit dem Anschluß der Eingangsschaltung verbunden.

## Revendications

1. Circuit à pompe à charge dans un oscillateur à phase asservie (PLL) avec un circuit numérique de comparaison de phase, comprenant:
- un montage en série d'un premier transistor (Q3) et d'un deuxième transistor (Q6) du type complémentaire du type dudit premier transistor, entre une borne à tension de source d'énergie et la masse;
- un troisième transistor (Q7) connecté audit deuxième transistor pour former un circuit à miroir de courant avec ledit deuxième transistor; et
- des moyens formant transistor (Q1, Q2) connectés audit premier transistor (Q3) et montés en série avec ledit troisième transistor (Q7) entre ladite borne à tension de source d'énergie et la masse,
caractérisé en ce que:
- un circuit d'entrée est prévu, ayant un montage en parallèle, entre une borne (T1) et la masse, d'une première résistance (R2), et un montage en série d'un transistor (Q9) et d'une deuxième résistance (R1), la borne de commande dudit transistor recevant une tension pour commander son état bloqué ou débloqué; et
- lesdits moyens formant transistor comprennent les particularités suivantes:
- ils sont constitués par un quatrième transistor (Q1) dans un circuit à miroir de courant avec ledit premier transistor (Q3), et un cinquième transistor (Q2), lesquels transistors sont de types complémentaires et ont leurs bornes de commande connectées l'une à l'autre;
- le cinquième transistor (Q2) étant monté en série avec ledit troisième transistor (Q7) entre ladite borne à tension de source d'énergie et la masse; et
- les bornes de commande desdits premier, quatrième et cinquième transistors sont connectées à la borne dudit circuit d'entrée.
